# EUROPEAN PATENT APPLICATION

(11) **EP 4 694 601 A1**
(43) Date of publication of application: **11.02.2026**
(21) Application number: 25191977.5
(22) Date of filing: 25.07.2025
(51) Int. Cl.: H05K 7/20, H01M 10/653, H01M 10/6553

(54) **INSULATION AND HEAT-DISSIPATION PAD AND ELECTRONIC DEVICE INCLUDING SAME**

(30) Priority: 31.07.2024 CN 202411049203
(71) Applicant: Illinois Tool Works Inc., Glenview IL 60025 (US)
(72) Inventor: SU, Run, Glenview, 60025 (US); KANG, Sijun, Glenview, 60025 (US)
(74) Representative: HGF

(57) **Abstract**

The present disclosure disclosed an insulation and heat-dissipation pad and an electronic device including same, the insulation and heat-dissipation pad comprises: a thermally conductive insulation film; and a thermosetting adhesive layer. The thermosetting adhesive layer is pre-bonded to the thermally conductive insulation film, and the thermosetting adhesive layer is configured to bond to a heat generating portion of a first component or a metal portion of a second component, so as to isolate the heat generating portion from the metal portion in an insulated manner. **In** the present disclosure, a thermosetting adhesive with a relatively small thickness can also have good bonding properties by selecting an appropriate thermally conductive insulation film and thermosetting adhesive. Further, by selecting an appropriate heating temperature, the thermosetting adhesive layer can also be firmly bonded between the thermally conductive insulation film and the heat generating portion or the metal portion while preventing the thermally conductive insulation film from being damaged by high temperature, so that the performance of the electronic device including the insulation and heat-dissipation pad of the present disclosure can be safer and more reliable.

## Description

### TECHNICAL FIELD

The present disclosure relates to the field of electronic devices, and in particular to an insulation and heat-dissipation pad and an electronic device including same.

### BACKGROUND

Electronic devices that include heat generating components are typically required to be provided with cooling components to dissipate heat generated by the heat generating components to avoid local overheating, which could affect the proper operation of the electronic device. The cooling components may include metal components with good thermal conduction properties. However, the metal components typically also have good electrical conductivity, so it is also necessary to provide insulation means between the heat generating components and the metal components.

### SUMMARY

A first aspect of the present disclosure provides an insulation and heat-dissipation pad, it comprises: a thermally conductive insulation film; and a thermosetting adhesive layer. The thermosetting adhesive layer is pre-bonded to the thermally conductive insulation film, and the thermosetting adhesive layer is configured to bond to a heat generating portion of a first component or a metal portion of a second component, so as to isolate the heat generating portion from the metal portion in an insulated manner.

According to the first aspect, the thermally conductive insulation film has an upper film surface and a lower film surface that are opposite to each other. The thermosetting adhesive layer has an upper adhesive surface and a lower adhesive surface that are opposite to each other. The lower adhesive surface of the thermosetting adhesive layer is pre-bonded to the upper film surface of the thermally conductive insulation film, the upper adhesive surface of the thermosetting adhesive layer is configured to bond to the heat generating portion of the first component, and the lower film surface of the thermally conductive insulation film is supported on the metal portion of the second component to conduct heat with the metal portion.

According to the first aspect, the thermosetting adhesive layer comprises at least one of the following materials: a polyester thermosetting glue, a polyamide thermosetting glue, a polyether thermosetting glue, a polyurethane thermosetting glue, copolymers of them, and copolymers of at least two of them.

According to the first aspect, the thermosetting adhesive layer comprises a saturated polyester thermosetting glue.

According to the first aspect, the thermosetting adhesive layer comprises a polyester thermosetting glue formed by a polycondensate of a diacid and a diol or a copolymer thereof.

According to the first aspect, the thermosetting adhesive layer has a thickness of 0.01-0.08 mm.

According to the first aspect, the thermosetting adhesive layer has a thickness of 0.015-0.08 mm.

According to the first aspect, the thermally conductive insulation film is a PP thermally conductive insulation film or a PC thermally conductive insulation film.

According to the first aspect, the thermally conductive insulation film has a thickness of 0.05-1 mm.

According to the first aspect, the thermally conductive insulation film has a thickness of 0.2-0.6 mm.

According to the first aspect, the thermal conductivity of the thermally conductive insulation film is greater than 0.5 W/m.K.

According to the first aspect, pre-bonding the thermosetting adhesive layer to the thermally conductive insulation film is achieved by means of a drying and bonding process.

According to the first aspect, the thermosetting adhesive layer is configured such that the thermosetting adhesive layer pre-bonded to the thermally conductive insulation film is bonded to the thermally conductive insulation film by means of a hot pressing process, and the thermosetting adhesive layer is bonded to the heat generating portion or the metal portion.

According to the first aspect, the hot pressing process is implemented by means of hot pressing for 5-20 minutes at a temperature of 125-145°C and a pressure of 2-15 MPa.

A second aspect of the present disclosure provides an electronic device, it comprises: a first component, a second component and the insulation and heat-dissipation pad according to any one of the first aspect. The first component comprises a heat generating portion, and the second component comprises a metal portion. The insulation and heat-dissipation pad is arranged between the heat generating portion and the metal portion to isolate the heat generating portion from the metal portion in an insulated and thermally conductive manner.

According to the second aspect, the first component comprises a battery module, a PCB or a metal busbar, and the second component comprises a cooling plate provided with a metal portion.

Other features, advantages, and embodiments of the present disclosure will be set forth or become apparent from the following specific embodiment, the accompanying drawings, and the claims. Furthermore, it should be understood that the above summary of the invention and the following detailed description are merely exemplary and are intended to provide further explanation, without limiting the scope of the present disclosure. It should also be understood that, although specific arrangements of the components are disclosed and illustrated in exemplary embodiments, other arrangements are also within the scope of the present application. However, the specific embodiments and specific examples only illustrate the preferred embodiments of the present disclosure. It will be apparent to those skilled in the art that various variations and modifications within the spirit and scope of the present disclosure will become evident from the specific embodiments.

### BRIEF DESCRIPTION OF THE DRAWINGS

Fig. 1A is a partial structural schematic view of an electronic device including an embodiment of an insulation and heat-dissipation pad of the present disclosure;
Fig. 1B is a partial front view of the electronic device of Fig. 1A;
Fig. 2 is a partial structural schematic view of an electronic device including another embodiment of the insulation and heat-dissipation pad of the present disclosure; and
Fig. 3 is a partial structural schematic view of an electronic device including still another embodiment of the insulation and heat-dissipation pad of the present disclosure.

### DETAILED DESCRIPTION OF EMBODIMENTS

Various specific embodiments of the present disclosure will be described below with reference to the drawings which form part of this specification. It is to be understood that although the terms indicating orientations, such as "front", "rear", "upper", "lower", "left", "right", "top", "bottom", "inner", "outer" are used in the present disclosure to describe orientations of structural parts and elements in various examples of the present disclosure, these terms are used herein only for ease of illustration and are determined based on the exemplary orientations shown in the accompanying drawings. Since the arrangements in the embodiments disclosed in the present disclosure may be in various directions, these terms indicating directions are only illustrative and should not be considered as limitations. Wherever possible, the same or similar reference numerals used in this disclosure refer to the same components.

In the present disclosure, unless otherwise specified, all devices and raw materials are commercially available or are commonly used in the industry, and the methods in the examples below are conventional in the art unless otherwise stated.

The insulation and heat-dissipation pad of the present disclosure is provided between a first component and a second component, for example between a heat generating portion of the first component and a metal portion of the second component, for isolating the heat generating portion from the metal portion in an insulated manner, and for dissipating heat generated by the heat generating portion toward the metal portion, so that not only can the heat be dissipated in a timely manner to ensure that the heat generating portion will not be subjected to local overheating, but the metal portion can also be prevented from conducting electricity.

In the present disclosure, the insulation and heat-dissipation pad includes a thermally conductive insulation film and a thermosetting adhesive layer. The thermosetting adhesive layer is pre-bonded to the thermally conductive insulation film, and the thermosetting adhesive layer is configured to be bonded to a heat generating portion of a first component or a metal portion of a second component, so that the thermally conductive insulation film and the thermosetting adhesive layer are located between the heat generating portion and the metal portion, to isolate the heat generating portion from the metal portion in an insulated and thermally conductive manner. In some embodiments, the first component is located above the second component, the thermosetting adhesive layer is bonded to the heat generating portion of the first component, and the thermally conductive insulation film is supported over the metal portion of the second component, to conduct heat with the metal portion, for example, conducting heat through direct contact or via a small gap. In this way, even if the first component is displaced relative to the second component, the thermally conductive insulation film is not displaced relative to the first component, and the first component can be guaranteed to be insulated from the second component. In some embodiments, it is also possible that the thermosetting adhesive layer is bonded to the metal portion of the second component, and the thermally conductive insulation film is supported under the heat generating portion of the first component, to conduct heat with the heat generating portion, for example, conducting heat through direct contact or via a small gap.

As an example, the thermally conductive insulation film has a thickness of 0.1-1 mm. In some more specific examples, the thermally conductive insulation film has a thickness of 0.2-0.6 mm. Moreover, the thermal conductivity of the thermally conductive insulation film is greater than 0.5 W/m.K, to ensure good thermal conduction properties of the thermally conductive insulation film. In addition, the surface resistivity of the thermally conductive insulation film is greater than 10¹³ Ω, to ensure that the thermally conductive insulation film has good insulation properties.

In some examples, the thermally conductive insulation film is a PP thermally conductive insulation film or a PC thermally conductive insulation film, which can have both good thermal conduction properties and insulation properties at a relatively thin thickness. The PP thermally conductive insulation film includes 20-80% by weight of PP resin and 20-70% by weight of thermally conductive filler. The PC thermally conductive insulation film includes 20-80% by weight of PC resin and 20-70% by weight of thermally conductive filler. In some more specific examples, the PP thermally conductive insulation film or the PC thermally conductive insulation film is a commercially available product.

As an example, the thermosetting adhesive layer has a thickness of 0.01-0.08 mm. In some more specific examples, the thermosetting adhesive layer has a thickness of 0.015-0.08 mm. In some embodiments, the material of the thermosetting adhesive layer includes a low-temperature thermosetting glue having a curing temperature of not greater than 150°C, for example including at least one of the following materials: a polyester thermosetting glue, a polyamide thermosetting glue, a polyether thermosetting glue, a polyurethane thermosetting glue, copolymers of them, and copolymers between at least two of them. In some embodiments, the material of the thermosetting adhesive layer is polyester thermosetting glue which has good low-temperature bonding properties and is particularly suitable for adhesion between other components. In some examples, the polyester thermosetting glue is a saturated polyester thermosetting glue. In some examples, the polyester thermosetting glue is a polyester thermosetting glue formed by a polycondensate of a diacid and a diol or a copolymer thereof. In some more specific examples, the polyester thermosetting glue is a commercially available product, such as the TM301 from Hehe Hot Melt Glue Co., Ltd.

The thermosetting adhesive forms a cross-linked structure when heated, and can firmly adhere the thermally conductive insulation film to a required location after cooled. In the present disclosure, the insulation and heat-dissipation pad is formed by pre-bonding the thermosetting adhesive to the thermally conductive insulation film. When required for use, the thermosetting adhesive layer of the insulation and heat-dissipation pad is brought into contact with the heat generating portion of the first component or the metal portion of the second component, and the thermosetting adhesive is then bonded to both the thermally conductive insulation film and the heat generating portion or the metal portion by means of heating and pressing, so that the thermally conductive insulation film can be bonded to the heat generating portion or the metal portion.

In some embodiments, pre-bonding the thermosetting adhesive to the thermally conductive insulation film is achieved by means of a drying process. Under the conditions of drying, the thermosetting adhesive can bond to the thermally conductive insulation film to form an insulation and heat-dissipation pad having a certain bonding strength, to meet the transportation requirements. However, the thermosetting adhesive does not form a cross-linked structure, that is, the thermosetting adhesive is not firmly bonded to the thermally conductive insulation film, so that the thermosetting adhesive can also be bonded to other parts. Those skilled in the art can select an appropriate drying temperature and drying time on the basis of the specific composition of the thermosetting adhesive to remove a solvent and other components of the thermosetting adhesive, so that the thermosetting adhesive can be pre-bonded to the thermally conductive insulation film. In some more specific embodiments, a thermosetting adhesive of a required thickness is applied on a surface of the thermally conductive insulation film by an operator, and then dried in a tunnel oven at about 120-150°C for 1-3 minutes to form a thermosetting adhesive layer adhered to the thermally conductive insulation film.

In some embodiments, the firm bonding of the thermosetting adhesive layer to the thermally conductive insulation film and the heat generating portion or the metal portion is achieved by means of a hot pressing process. Under the conditions of hot pressing, one surface of the thermosetting adhesive is firmly bonded to the thermally conductive insulation film, and the other surface of the thermosetting adhesive is firmly bonded to the heat generating portion or the metal portion. In some more specific embodiments, after the operator covers the insulation and heat-dissipation pad over the heat generating portion, the insulation and heat-dissipation pad and the metal portion are hot pressed at a temperature of 125-145°C and a pressure of 2-15 MPa for 5-20 minutes, and then are cooled, so that the thermally conductive insulation film and the heat generating portion that are firmly bonded by means of the thermosetting adhesive layer can be obtained.

The applicant has found that the thermosetting adhesive generally does not have a positive effect on the heat dissipation of the insulation and heat-dissipation pad. The smaller in the thickness the thermosetting adhesive layer is, the smaller the negative effect the thermosetting adhesive layer has on the heat dissipation of the insulation and heat-dissipation pad, but too small the thickness of the thermosetting adhesive layer may affect the bonding properties of the thermosetting adhesive. Moreover, when the thickness of the thermally conductive insulation film is relatively small, the heat resistance temperature is generally not too high. When the thermosetting adhesive is heated, the properties of the thermally conductive insulation film may be compromised. Especially for films including PP resin and PC resin, if the heating temperature is too high, the films will melt and cannot provide the thermally conductive insulation function.

In the present disclosure, a thermosetting adhesive with a relatively small thickness can also have good bonding properties by selecting an appropriate thermally conductive insulation film and thermosetting adhesive. Further, by selecting an appropriate heating temperature, the thermosetting adhesive layer can also be firmly bonded between the thermally conductive insulation film and the heat generating portion or the metal portion while preventing the thermally conductive insulation film from being damaged by high temperature, so that the performance of the electronic device including the insulation and heat-dissipation pad of the present disclosure can be safer and more reliable.

The effect of the insulation and heat-dissipation pad of the present disclosure is illustrated below by means of Examples 1-4 of specific insulation and heat-dissipation pads and Comparative Examples 1-5 of insulation pads. Table 1 shows a comparison of the composition thickness and properties of samples of the examples of the present disclosure and comparative examples.

**Table 1 shows a comparison of the composition thickness and properties of samples of the examples of the present disclosure and comparative examples**

| | Example 1 | Example 2 | Example 3 | Example 4 | Example 5 | Example 6 |
|---|---|---|---|---|---|---|
| PP thermally conductive insulation film | 0.25 mm | 0.05 mm | 0.6 mm | | 0.2 mm | 0.76 mm |
| PC thermally conductive insulation film | | | | 0.2 mm | | |
| Non-thermal ly conductive insulation film | | | | | | |
| Polyester thermosettin g glue | 0.04 mm | 0.015 mm | 0.08 mm | 0.04 mm | 0.04 mm | 0.05 mm |
| Epoxy thermosettin g glue | | | | | | |
| Double-side d glue | | | | | | |
| Hot melt glue | | | | | | |
| Thermal conductivity | > 0.5 W | > 0.5 W | > 0.5 W | > 0.5 W | > 0.5 W | > 0.5 W |
| Peel force | > 13 N/cm | > 13 N/cm | > 15 N/cm | > 15 N/cm | > 13 N/cm | > 13 N/cm |
| Hot pressing time | 5 | 5 | 10 | 5 | 20 | 10 |
| Hot pressing temperature | 130 | 130 | 130 | 130 | 125 | 145 |

| | Comparative Example 1 | Comparative Example 2 | Comparative Example 3 | Comparative Example 4 | Comparative Example 5 | Comparative Example 6 |
|---|---|---|---|---|---|---|
| PP thermally conductive insulation film | 0.25 mm | 0.25 mm | | | | 0.25 mm |
| PC thermally conductive insulation film | | | | | 0.2 mm | |
| Non-thermally conductive insulation film | | | 0.25 mm | 0.25 mm | | |
| Polyester thermosetting glue | | | 0.04 mm | | | |
| Epoxy thermosetting glue | 0.04 mm | | | | | |
| Double-sided glue | | 0.05 mm | | 0.08 mm | 0.05 mm | |
| Hot melt glue | | | | | | 0.08 mm |
| Thermal conductivity | > 0.5 W | > 0.4 W | < 0.3 W | < 0.3 W | > 0.4 W | >0.4W |
| Peel force | < 8 N/cm | < 8 N/cm | > 13 N/cm | < 8 N/cm | < 8 N/cm | < 8 N/cm |
| Hot pressing time | 10 | 0 | 5 | 0 | 0 | 5 |
| Hot pressing temperature | 145 | - | 130 | - | - | 130 |

In Table 1, the PP thermally conductive insulation film is Formex^{®} TCI, the PC thermally conductive insulation film is Formex^{®} PCTCI, the non-thermally conductive insulation film is a commercially available roll of PET substrate; the polyester thermosetting glue is TM301 from Hehe Company; the epoxy thermosetting glue is BL-ER500 from Banglan Electronics; the double-sided glue is 9495LE from 3M Company; and the hot melt glue is F701 from Shanghai Tianyang. The thermal conductivity was obtained by testing the insulation and heat-dissipation pads of Examples 1-4 and the heat-dissipation pads of Comparative Examples 1-5, according to the test method of ASTM D5470-12. The peel force was obtained by testing the insulation and heat-dissipation pads of Examples 1-4 and the heat-dissipation pads of Comparative Examples 1-5 that have been placed at -30°C for 1 hour, using the 180° T-peel force test method. It should be noted that the heat generating portion of the first component is generally made of a metallic material or a plastic material, and the bonding strength between the heat generating portion and various glues is better than the bonding strength between the glue and the film, so that peeling mainly occurs between the glue and the film or is caused by the damage of the film itself. The property results tested in Table 1 are therefore the properties of the corresponding insulation film and a standard thermally conductive aluminum sheet after being adhered by means of the corresponding glue.

As can be seen from the above Table 1, the insulation and heat-dissipation pads of Examples 1-4 not only have good thermal conductivity, but also have very good bonding strength even under low-temperature conditions and are not easy to peel off. The insulation and heat-dissipation pad of Example 2 requires only 0.05 mm of thermally conductive insulation film and 0.015 mm of polyester thermosetting glue to achieve very good thermal conductivity and bonding strength with a total thickness of less than 0.1 mm. Moreover, in a certain range, the larger in the thickness the polyester thermosetting glue has, the higher bonding strength the polyester thermosetting adhesive will have. The heat-dissipation pads of Comparative Examples 1-2 and 5-6 include a thermally conductive insulation film, so that the heat-dissipation pads of Comparative Examples 1-2 and 5-6 have good thermal conductivity. However, Comparative Example 1 used the epoxy thermosetting glue, Comparative Example 2 and Comparative Example 5 used the double-sided glue, and Comparative Example 6 used the hot melt glue, so that the bonding strength between glue and the thermally conductive insulation film is insufficient, resulting in small peel force, and the thermally conductive insulation film is thus easy to be peeled off. Moreover, by comparing the heat-dissipation pads of Comparative Examples 5 and 6 with the insulation and heat-dissipation pads of Examples 1 and 4, while Comparative Examples 5 and 6 include a thermally conductive insulation film, the thermal conductivities thereof are both lower than those of the insulation and heat-dissipation pads of Examples 1 and 4, indicating that the negative effects of the double-sided glue and the hot melt glue on thermal conductivity are greater than the negative effect of the polyester thermosetting glue on thermal conductivity. Although the heat-dissipation pad of Comparative Example 3 uses the polyester thermosetting glue to bond the film to the metal component to provide good bonding strength, the heat-dissipation pad of Comparative Example 3 includes a non-thermally conductive insulation film, resulting in poor thermal conductivity.

It can be seen from this that the thermally conductive insulation film is particularly suitable for bonding with the polyester thermosetting glue. The polyester thermosetting glue layer can not only firmly bond the thermally conductive insulation film to the heat generating portion with a relatively thin thickness, but can also make the insulation and heat-dissipation pad have good thermal conductivity.

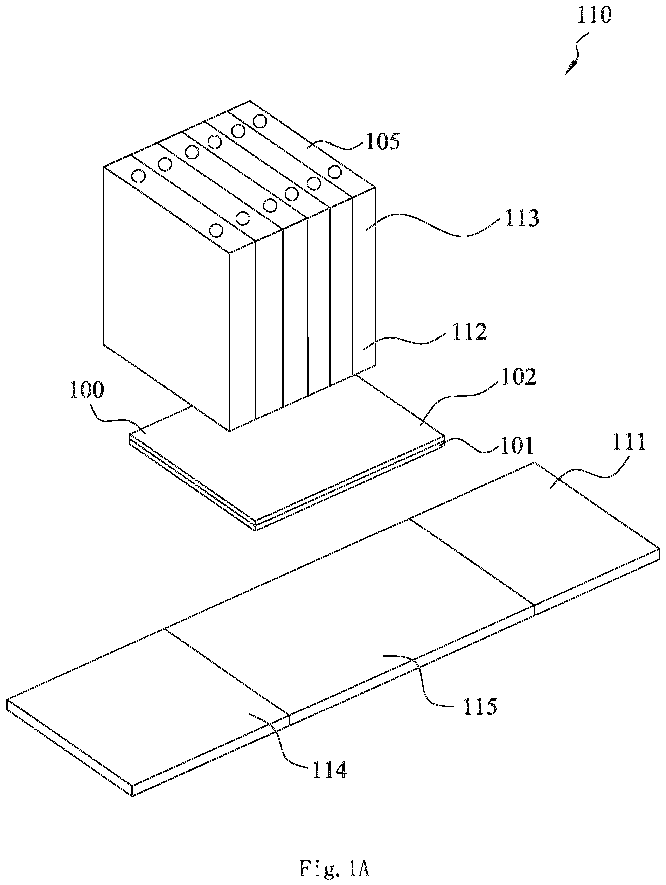

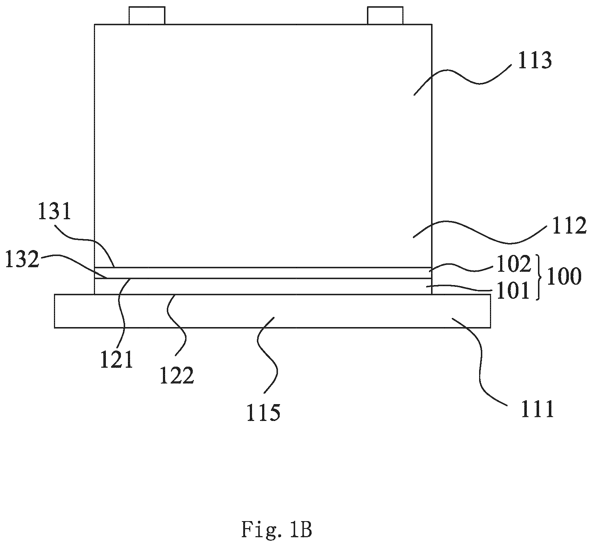

Figs. 1A and 1B are partial structural schematic views of an electronic device including an embodiment of an insulation and heat-dissipation pad of the present disclosure. Fig. 1A shows a partial structure of the electronic device when the insulation and heat-dissipation pad has not been adhered to a second component, and Fig. 1B shows a partial structure of the electronic device when the insulation and heat-dissipation pad is adhered to the second component. As shown in Figs. 1A and 1B, the electronic device includes a battery device 110. The battery device 110 includes a first component 113 and a second component 111, and an insulation and heat-dissipation pad 100 is arranged between the first component 113 and the second component 111, to isolate the first component 113 from the second component 111 in an insulated and thermally conductive manner. In the embodiment shown in that figures, the first component 113 is a battery module, which includes a heat generating portion 112, and has a battery housing 105 made of a metallic material. When the battery module is in operation, the battery module can generate heat. The second component 111 is a cooling plate, which includes a metal portion 115 made of metal with good thermal conduction properties. The insulation and heat-dissipation pad 100 is disposed between the heat generating portion 112 and the metal portion 115 in an insulated and thermally conductive manner. In this embodiment, the first component 113 can generate heat as a whole so that the whole first component forms the heat generating portion 112. In other embodiments, the first component 113 may partially generate heat and form the heat generating portion at its heat generating part, and the insulation and heat-dissipation pad is located under the corresponding heat generating portion. Moreover, in this embodiment, the second component 111 as a whole is made of a metallic material, that is, the rest portion 114 of the second component 111 other than the metal portion 115 is also made of metal. In other embodiments, it is also possible that the second component 111 is partially made of a metallic material. For example, in some embodiments, the rest portion 114 may be a coating of a non-metallic material covering the metallic material, or be made of a non-metallic material.

The insulation and heat-dissipation pad 100 includes a thermally conductive insulation film 101 and a thermosetting adhesive layer 102. In this embodiment, the thermosetting adhesive layer 102 of the insulation and heat-dissipation pad 100 is adhered to the heat generating portion 112, and the thermally conductive insulation film 101 is in contact with the metal portion 115 to conduct heat. Specifically, the thermally conductive insulation film 101 has an upper film surface 121 and a lower film surface 122 that are opposite to each other. The thermosetting adhesive layer 102 has an upper adhesive surface 131 and a lower adhesive surface 132 that are opposite to each other. When the insulation and heat-dissipation pad 100 has not been adhered to the heat generating portion 112, the lower adhesive surface 132 is pre-bonded to the upper film surface 121, for example, the lower adhesive surface 132 is pre-bonded to the upper film surface 121 by means of a drying process. The upper adhesive surface 131 is aligned with and faces a lower surface of the heat generating portion 112. The lower film surface 122 of the thermally conductive insulation film 101 is supported over the metal portion 115 and is in contact with the metal portion 115.

After the thermosetting adhesive layer 102 of the insulation and heat-dissipation pad 100 attaches to the lower surface of the heat generating portion 112, a hot pressing process is performed on the thermosetting adhesive layer 102 such that the lower adhesive surface 132 pre-bonded to the upper film surface 121 is bonded to the upper film surface 121, and the upper adhesive surface 131 is bonded to the lower surface of the heat generating portion 112. Moreover, in this embodiment, the size of the insulation and heat-dissipation pad 100 is substantially the same as the size of the heat generating portion 112, and both are smaller than the size of the metal portion 115. Therefore, even if there is a relative displacement between the heat generating portion 112 and the metal portion 115, the insulation and heat-dissipation pad 100 can be firmly adhered under the heat generating portion 112, ensuring that electricity will not be leaked from the battery module to the metal portion 115.

In this way, the battery device including the insulation and heat-dissipation pad 100 of the present embodiment can both cool the heat generating portion 112 by means of the metal portion 115 and prevent the metal portion 115 from conducting electricity, making it particularly suitable for battery devices including thermal management systems.

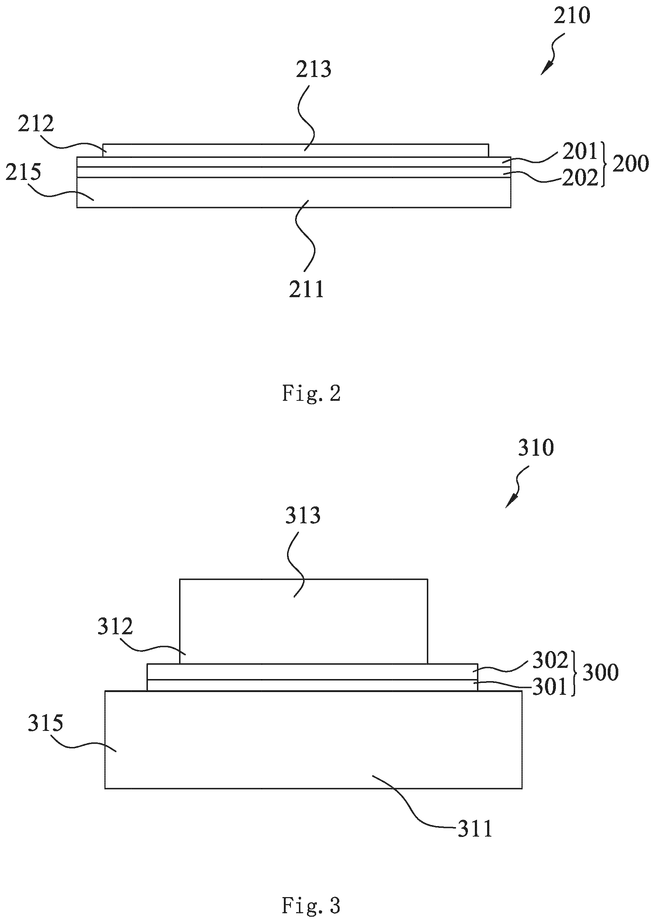

Fig. 2 is a partial structural schematic view of an electronic device including another embodiment of the insulation and heat-dissipation pad of the present disclosure. As shown in Fig. 2, the electronic device 210 includes a first component 213 and a second component 211. The first component 213 includes a heat generating portion 212, and the second component 211 includes a metal portion 215. In this embodiment, the first component 213 is a PCB, which generates heat as a whole. The second component 211 as a whole is a cooling plate made of a metallic material, which includes a metal portion 115. Moreover, in this embodiment, an insulation and heat-dissipation pad 200 is supported under the PCB, and a thermally conductive insulation film 201 of the insulation and heat-dissipation pad 200 tightly abuts against a side surface of the PCB where no electrical components are provided. A thermosetting adhesive layer 202 of the insulation and heat-dissipation pad 200 is adhered to an upper surface of the metal portion 215 to isolate the heat generating portion 212 of the PCB from the metal portion 215 of the cooling plate in an insulated and thermally conductive manner. In this embodiment, the size of the insulation and heat-dissipation pad 100 is substantially the same as the size of the metal portion 215, and both are larger than the size of the heat generating portion 212. Therefore, even if there is a relative displacement between the heat generating portion 212 and the metal portion 215, the insulation and heat-dissipation pad 200 can be firmly adhered over the metal portion 215, ensuring that electricity will not be leaked from the PCB to the metal portion 215.

In this way, the PCB including the insulation and heat-dissipation pad 200 of the present embodiment can be cooled by means of the metal portion 215, and the proper operation of the PCB can also be prevented from being affected by conducting electricity via metal, making it particularly suitable for PCBs capable of thermal management.

Fig. 3 is a partial structural schematic view of an electronic device including still another embodiment of the insulation and heat-dissipation pad of the present disclosure. As shown in Fig. 3, the electronic device 310 includes a first component 313 and a second component 311. The first component 313 includes a heat generating portion 312, and the second component 311 includes a metal portion 315. In this embodiment, the first component 313 and the second component 311 are both metal busbars. That is, the first component 311 and the second component 311 can both generate heat and are each made of a metallic material.

However, the temperatures of the first component 313 and the second component 311 are different. As an example, by designing parameters such as power of the metal busbars, it is possible for the first component 313 and the second component 311 to have different operating temperatures. In this embodiment, the temperature of the metal busbar of the first component 313 is higher than the temperature of the metal busbar of the second component 311, so that the first component 313 as a whole forms the heat generating portion 312, and the second component 311 as a whole forms the metal portion 315 for cooling the first component 313.

The insulation and heat-dissipation pad 300 is adhered under the metal busbar of the first component 313, and the thermosetting adhesive layer 302 of the insulation and heat-dissipation pad 300 is adhered to a lower surface of the metal busbar of the first component 313. After the thermally conductive insulation film 301 of the insulation and heat-dissipation pad 300 tightly abuts against an upper surface of the metal busbar of the second component 311, the metal busbar of the first component 313 can be isolated from the metal busbar of the second component 311 in an insulated and thermally conductive manner.

In this way, the metal busbar group including the insulation and heat-dissipation pad 300 of this embodiment can cool the metal busbar with a higher temperature by using the metal busbar with a lower temperature, so as to maintain the temperature balance inside the metal busbar group. Moreover, it is possible to prevent the influence of electrical conduction between the metal busbars, making it particularly suitable for metal busbar groups capable of thermal management.

Although the present disclosure is described with reference to the examples of the embodiments outlined above, various alternatives, modifications, variations, improvements and/or substantial equivalents, whether are known or can be anticipated at present or to be anticipated in future, may be obvious to those of at least ordinary skill in the art. Accordingly, the examples of the embodiments of the present disclosure as set forth above are intended to be illustrative rather than limiting. Various changes may be made without departing from the spirit or scope of the present disclosure. Therefore, the present disclosure is intended to encompass all known or earlier-developed alternatives, modifications, variations, improvements, and/or substantial equivalents. The technical effects and/or technical problems in this specification are exemplary rather than limiting. It should be noted, the embodiments in this specification may solve other technical problems and have other technical effects.

Certain embodiments of the invention are described in the following clauses:
Clause 1. An insulation and heat-dissipation pad, comprising:
   a thermally conductive insulation film; and
   a thermosetting adhesive layer;
   wherein the thermosetting adhesive layer is pre-bonded to the thermally conductive insulation film, and the thermosetting adhesive layer is configured to bond to a heat generating portion of a first component or a metal portion of a second component, so as to isolate the heat generating portion from the metal portion in an insulated manner.
Clause 2. The insulation and heat-dissipation pad according to clause 1, wherein
   the thermally conductive insulation film has an upper film surface and a lower film surface that are opposite to each other;
   the thermosetting adhesive layer has an upper adhesive surface and a lower adhesive surface that are opposite to each other;
   wherein the lower adhesive surface of the thermosetting adhesive layer is pre-bonded to the upper film surface of the thermally conductive insulation film, the upper adhesive surface of the thermosetting adhesive layer is configured to bond to the heat generating portion of the first component, and the lower film surface of the thermally conductive insulation film is supported on the metal portion of the second component to conduct heat with the metal portion.
Clause 3. The insulation and heat-dissipation pad according to clause 1, wherein
   the thermosetting adhesive layer comprises at least one of the following materials: a polyester thermosetting glue, a polyamide thermosetting glue, a polyether thermosetting glue, a polyurethane thermosetting glue, copolymers of them, and copolymers of at least two of them.
Clause 4. The insulation and heat-dissipation pad according to clause 3, wherein
   the thermosetting adhesive layer comprises a saturated polyester thermosetting glue.
Clause 5. The insulation and heat-dissipation pad according to clause 4, wherein
   the thermosetting adhesive layer comprises a polyester thermosetting glue formed by a polycondensate of a diacid and a diol or a copolymer thereof.
Clause 6. The insulation and heat-dissipation pad according to clause 1, wherein
   the thermosetting adhesive layer has a thickness of 0.01-0.08 mm.
Clause 7. The insulation and heat-dissipation pad according to clause 6, wherein
   the thermosetting adhesive layer has a thickness of 0.015-0.08 mm.
Clause 8. The insulation and heat-dissipation pad according to clause 1, wherein
   the thermally conductive insulation film is a PP thermally conductive insulation film or a PC thermally conductive insulation film.
Clause 9. The insulation and heat-dissipation pad according to clause 1, wherein
   the thermally conductive insulation film has a thickness of 0.05-1 mm.
Clause 10. The insulation and heat-dissipation pad according to clause 9, wherein
   the thermally conductive insulation film has a thickness of 0.2-0.6 mm.
Clause 11. The insulation and heat-dissipation pad according to clause 1, wherein
   the thermal conductivity of the thermally conductive insulation film is greater than 0.5 W/m.K.
Clause 12. The insulation and heat-dissipation pad according to clause 1, wherein
   pre-bonding the thermosetting adhesive layer to the thermally conductive insulation film is achieved by means of a drying and bonding process.
Clause 13. The insulation and heat-dissipation pad according to clause 12, wherein
   the thermosetting adhesive layer is configured such that the thermosetting adhesive layer pre-bonded to the thermally conductive insulation film is bonded to the thermally conductive insulation film by means of a hot pressing process, and the thermosetting adhesive layer is bonded to the heat generating portion or the metal portion.
Clause 14. The insulation and heat-dissipation pad according to clause 13, wherein
   the hot pressing process is implemented by means of hot pressing for 5-20 minutes at a temperature of 125-145°C and a pressure of 2-15 MPa.
Clause 15. An electronic device, comprising:
   a first component comprising a heat generating portion;
   a second component comprising a metal portion; and
   the insulation and heat-dissipation pad according to any one of clauses 1-14, the insulation and heat-dissipation pad being arranged between the heat generating portion and the metal portion to isolate the heat generating portion from the metal portion in an insulated and thermally conductive manner.
Clause 16. The electronic device according to clause 15, wherein
   the first component comprises a battery module, a PCB or a metal busbar; and
   the second component comprises a cooling plate provided with a metal portion.

## Claims

1. An insulation and heat-dissipation pad, comprising:
a thermally conductive insulation film; and
a thermosetting adhesive layer;
wherein the thermosetting adhesive layer is pre-bonded to the thermally conductive insulation film, and the thermosetting adhesive layer is configured to bond to a heat generating portion of a first component or a metal portion of a second component, so as to isolate the heat generating portion from the metal portion in an insulated manner.

2. The insulation and heat-dissipation pad according to claim 1, wherein
the thermally conductive insulation film has an upper film surface and a lower film surface that are opposite to each other;
the thermosetting adhesive layer has an upper adhesive surface and a lower adhesive surface that are opposite to each other;
wherein the lower adhesive surface of the thermosetting adhesive layer is pre-bonded to the upper film surface of the thermally conductive insulation film, the upper adhesive surface of the thermosetting adhesive layer is configured to bond to the heat generating portion of the first component, and the lower film surface of the thermally conductive insulation film is supported on the metal portion of the second component to conduct heat with the metal portion.

3. The insulation and heat-dissipation pad according to claim 1 or claim 2, wherein
the thermosetting adhesive layer comprises at least one of the following materials: a polyester thermosetting glue, a polyamide thermosetting glue, a polyether thermosetting glue, a polyurethane thermosetting glue, copolymers of them, and copolymers of at least two of them.

4. The insulation and heat-dissipation pad according to claim 3, wherein
the thermosetting adhesive layer comprises a saturated polyester thermosetting glue, and optionally wherein
the thermosetting adhesive layer comprises a polyester thermosetting glue formed by a polycondensate of a diacid and a diol or a copolymer thereof.

5. The insulation and heat-dissipation pad according to any one of claims 1 to 4, wherein the thermosetting adhesive layer has a thickness of 0.01-0.08 mm.

6. The insulation and heat-dissipation pad according to claim 5, wherein
the thermosetting adhesive layer has a thickness of 0.015-0.08 mm.

7. The insulation and heat-dissipation pad according to any one of claims 1 to 6, wherein
the thermally conductive insulation film is a PP thermally conductive insulation film or a PC thermally conductive insulation film.

8. The insulation and heat-dissipation pad according to any one of claims 1 to 7, wherein the thermally conductive insulation film has a thickness of 0.05-1 mm.

9. The insulation and heat-dissipation pad according to claim 8, wherein
the thermally conductive insulation film has a thickness of 0.2-0.6 mm.

10. The insulation and heat-dissipation pad according to any one of claims 1 to 9, wherein the thermal conductivity of the thermally conductive insulation film is greater than 0.5 W/m.K.

11. The insulation and heat-dissipation pad according to anyone of claims 1 to 10, wherein pre-bonding the thermosetting adhesive layer to the thermally conductive insulation film is achieved by means of a drying and bonding process.

12. The insulation and heat-dissipation pad according to claim 11, wherein
the thermosetting adhesive layer is configured such that the thermosetting adhesive layer pre-bonded to the thermally conductive insulation film is bonded to the thermally conductive insulation film by means of a hot pressing process, and the thermosetting adhesive layer is bonded to the heat generating portion or the metal portion.

13. The insulation and heat-dissipation pad according to claim 12, wherein
the hot pressing process is implemented by means of hot pressing for 5-20 minutes at a temperature of 125-145°C and a pressure of 2-15 MPa.

14. An electronic device, comprising:
a first component comprising a heat generating portion;
a second component comprising a metal portion; and
the insulation and heat-dissipation pad according to any one of claims 1-13, the insulation and heat-dissipation pad being arranged between the heat generating portion and the metal portion to isolate the heat generating portion from the metal portion in an insulated and thermally conductive manner.

15. The electronic device according to claim 14, wherein
the first component comprises a battery module, a PCB or a metal busbar; and
the second component comprises a cooling plate provided with a metal portion.
